# EUROPÄISCHE PATENTSCHRIFT

(11) **EP 1 947 920 B1**
(45) Veröffentlichungstag und Bekanntmachung des Hinweises auf die Patenterteilung: **05.12.2012**
(21) Anmeldenummer: 07123274.8
(22) Anmeldetag: 14.12.2007
(51) Int. Cl.: H05K 7/20

(54) **Sanftanlaufgerät mir einer Kühlanordnung**
Soft starter with a cooling device
Coupe-circuit de démarreur avec un dispositif de refroidissement

(30) Priorität: 17.01.2007 DE 102007003329
(43) Veröffentlichungstag der Anmeldung: 23.07.2008
(73) Patentinhaber: SIEMENS AKTIENGESELLSCHAFT, 80333 München (DE)
(72) Erfinder: Dornauer, Marco, 90562 Heroldsberg (DE); Reichenbach, Norbert, 92224 Amberg (DE)

(56) Entgegenhaltungen:
- WO-A-01/86681
- DE-A1- 10 330 315
- DE-A1-102004 017 292
- DE-U1-202005 004 448
- JP-A- 9 275 658

## Beschreibung

Die Erfindung betrifft Kühlanordnungen für elektrische Komponenten eines Sanftanlaufgerätes, sowie Sanftanlaufgeräte.

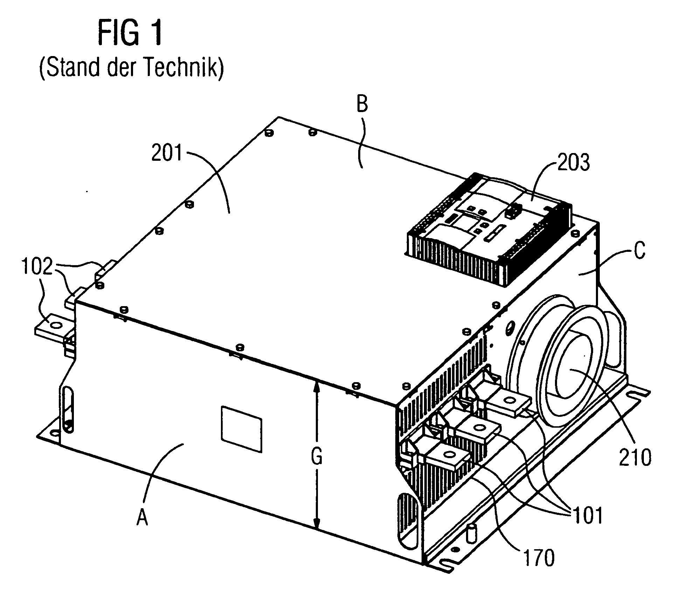

Moderne Sanftanlaufgeräte, wie in FIG 1 dargestellt, bestehen aus einem Halbleiterleistungsteil für den Motoranlauf und aus einem Überbrückungsteil für die Stromführung in der Betriebsphase. Das Überbrückungsteil kann beispielsweise durch ein mechanisches Schütz realisiert werden. Durch das Überbrückungsteil werden die elektrischen Verluste in der Betriebsphase erheblich reduziert, was kleinere Geräteabmessungen ermöglicht und die Kühlmaßnahmen beim Anwender reduziert. In den älteren Sanftanlaufgeräten besteht das Überbrückungsteil aus einem Schütz mit einer Lichtbogenlöschkammer.

Durch geeignete Ansteuerung vom Halbleiterteil und Überbrückungsteil durch ein Steuerteil kann beim Stromwechsel vom Halbleiterteil auf das Überbrückungsteil und umgekehrt eine Lichtbogenbildung nahezu vermieden werden. Das Überbrückungsteil kann deshalb auch ohne Lichtbogenlöschkammer konstruiert werden, was die Kosten, die Abmessungen und das Gewicht deutlich reduziert. Eine Ausführungsform von der erwähnten Konstruktion wird in der nicht vorveröffentlichten internationalen Anmeldung PCT/EP2005/012441 näher erläutert.

Das Dokument WO 01/86681 A1 offenbart ein Sanftanlaufgerät mit einem Gehäuse, mit elektrischen Komponenten innerhalb des Gehäuses und mit einem Gebläse, wobei die elektrischen Komponenten eine Schaltstelle umfassen.

Der Kühlungseffekt kann weiter verbessert werden mit mindestens einem Lüfter, der einen Kühlluftstrom über die Strombahnen und bevorzugt auch über die Kühlmaßnahmen bläst. Um einen ausreichenden Kühlluftstrom erzeugen zu können, ist der Lüfter bevorzugt ausreichend groß. Außerdem wird der Lüfter bevorzugt so platziert, dass der Luftstrom möglichst optimal die Strombahnen und Oberflächen vergrößernde Kühlmaßnahmen umströmt und kühlt. Bevorzugt wird der Lüfter deswegen an die Gehäusedeckel B des Sanftanlaufgeräts gebracht.

In einem Fehlerfall, oder wenn die Ansteuerung des Halbleiterteils durch den Steuerteil nicht genau funktioniert, kann es passieren, dass es bei dem Überbrückungsteil zu einer Lichtbogenbildung kommt. Damit der Lichtbogenüberschlag den Lüfter nicht beschädigt, muss der Lüfter weiter von dem Überbrückungsteil entfernt werden, was das Gerätevolumen, insbesondere die Höhe, vergrößert. Dies ist von Nachteil, weil es die Kundenattraktivität des Sanftanlaufgeräts reduzieren kann.

Es ist Aufgabe der Erfindung, eine verbesserte Kühlung eines elektrischen Gerätes zu ermöglichen, ohne dass das elektrische Gerät sehr viel höher gebaut werden muss.

Die Aufgabe kann mit einem Sanftanlaufgerät gemäß Anspruch 1 gelöst werden. Wenn das Sanftanlaufgerät mindestens ein Gebläse aufweist, das schräg in das Gehäuse eingebaut und ausgebildet ist, eine Fluidströmung von außerhalb des Gehäuses zu den zu kühlenden elektrischen Komponenten zu erzeugen, die im Betrieb als mindestens potenzielle geräteinterne Wärmequellen funktionieren, kann die Vergrößerung des Gerätevolumens durch eine größere Bautiefe besser vermieden werden. Bevorzug kann das Gebläse derart schräg montiert werden, dass seine Drehachse zur Senkrechten der Gehäusewand bzw. des Gehäusedeckels geneigt ist.

Die unter- bzw. nebengeordneten Ansprüche beschreiben vorteilhafte Ausführungsformen der Erfindung.

Wenn die mindestens eine potenzielle geräteinterne Wärmequelle mindestens eine Schaltstelle umfasst, die ausgebildet ist, einen elektrischen Strom zu unterbrechen, kann die mindestens eine Schaltstelle gekühlt werden. Vorteilhafterweise funktioniert die Erfindung auch mit mindestens einer Schaltstelle, die ausgebildet ist, einen elektrischen Strom ohne Verwendung einer Lichtbogenlöschkammer zu unterbrechen. In diesem Falle kann die Beschädigung des Gebläses durch einen Schaltlichtbogen dank des schrägen Einbaus besser vermieden werden.

Insbesondere kann das Gebläse dann weiter entfernt von der mindestens einen Schaltstelle montiert werden, was eine kleinere Geräteabmessung ermöglicht. Dann kann die Kühlwirkung verbessert werden, wenn die Drehachse zu der Schaltstelle gerichtet oder geneigt ist.

Wenn die mindestens eine potenzielle geräteinterne Wärmequelle mindestens eine Strombahn umfasst, kann die Kühlwirkung verbessert werden, ohne dass die Baugröße des elektrischen Gerätes im Wesentlichen erhöht werden muss.

Wenn das Gebläse im Gehäusedeckel B, wie in der FIG 1 markiert, montiert werden würde, um die mindestens eine Strombahn direkt von oben zu kühlen, müsste die Gehäusehöhe erhöht werden. Wenn das Gebläse mit einer parallel zu der mindestens einen Strombahn laufenden Drehachse in der Gehäusewand C, wie in der FIG 1 markiert, montiert werden würde, müsste die Gerätehöhe eventuell auch erhöht werden, weil gegebenenfalls neben dem Gebläse ein weiterer Platzbedarf für das elektrische Kontaktieren des Sanftanlaufgerätes zu einem möglichen Verbraucher oder zu einer Stromzufuhr besteht.

Wenn das Gebläse entfernt von der mindestens einen Strombahn gesetzt ist, oder wenn die Drehachse zu der mindestens einen Strombahn gerichtet oder geneigt ist, kann eine eventuelle Beschädigung des Gebläses wegen einer Bewegung des möglicherweise woanders auftretenden Schaltlichtbogens, der entlang der mindestens einen Strombahn heraustritt, besser vermieden werden.

Wenn die mindestens eine Strombahn eine Oberfläche aufweist, und die Drehachse so gewählt ist, dass das Gebläse eine Fluidströmung entlang der Oberfläche erzeugt, kann die Kühlwirkung der Strombahn noch verbessert werden, insbesondere wenn die Oberfläche im Wesentlichen flach ist, da dann eine unbehinderte Fluidströmung besser entstehen kann.

Bevorzugt ist das elektrische Gerät ein Sanftanlaufgerät mit mindestens einem Halbleiterleistungsteil und mit mindestens einem lichtbogenlöschkammerlosen Überbrückungsteil. In diesem Fall bildet das Überbrückungsteil die mindestens eine potenzielle geräteinterne Wärmequelle. Mit einer erfindungsgemäßen Ausführungsform können die wegen der bei gängigen Baugrößen vorkommenden großen Kurzschlussströme erforderliche aufwändige Erdung und metallische Abschirmung des Gebläses vermieden werden, was zu einer Aufwand- und Kosteneinsparung führen kann. Außerdem kann die Montage des Gebläses mit einem größeren Abstand direkt oberhalb der zu kühlenden Stellen vermieden werden, wodurch die unerwünschte Vergrößerung der Bautiefe des Geräts auch vermieden werden kann.

Im Folgenden wird die Erfindung anhand der Beispiele in der FIG 1 bis 4 näher beschrieben, von denen zeigen:
- FIG 1: ein Sanftanlaufgerät aus dem Stand der Technik
- FIG 2: ein lichtbogenlöschkammerloses Überbrückungsteil
- FIG 3: ein elektrisches Gerät in Perspektivdarstellung, und
- FIG 4: ein Längsschnitt des in der FIG 3 dargestellten elektrischen Gerätes.

Dieselben Bezugszeichen weisen auf dieselben strukturellen Merkmale in allen Figuren hin.

FIG 1 zeigt ein Sanftanlaufgerät 200 für Drehstromanwendungen. Das Sanftanlaufgerät ist in einem Gehäuse 201 eingeschlossen und wird mit Stromeingängen 102 zur Stromzufuhr und mit Stromausgängen 101 zu einem oder mehreren Verbrauchern, wie z.B. einem Motor, angeschlossen.

Die Rückseite des Gehäuses 201 wird bevorzugt an die Wand befestigt, somit läuft die Vorderseite oder der Gehäusedeckel B des Gehäuses 201 dann bevorzugt parallel zu der Wand. In der montierten Stellung zeigen die Stromeingänge 102 nach oben und die Unterseite C mit den Stromausgängen 101 nach unten. Die Seitenwand A bleibt dann auf bevorzugte Weise senkrecht zum Boden.

Das Sanftanlaufgerät 200 weist ein Halbleiterleistungsteil, ein Steuerteil 203 und ein Überbrückungsteil auf. Das Steuerteil 203 steuert den Wechsel zwischen dem Halbleiterleistungsteil und dem Überbrückungsteil an, so dass der Anlauf und Auslauf mit dem Halbleiterleistungsteil angesteuert werden, während im Stillstand sowie im Betrieb der Strom über das Überbrückungsteil geleitet wird. Das Halbleiterteil wird mit einem Lüfter 210 direkt gelüftet, dessen Blasrichtung bevorzugt von unten nach oben läuft.

Grundsätzlich ist man bestrebt, ein einziges Überbrückungsteil für einen möglichst weiten Strombereich einzusetzen, um die Varianz bei den Gehäuseausführungen möglichst gering zu halten

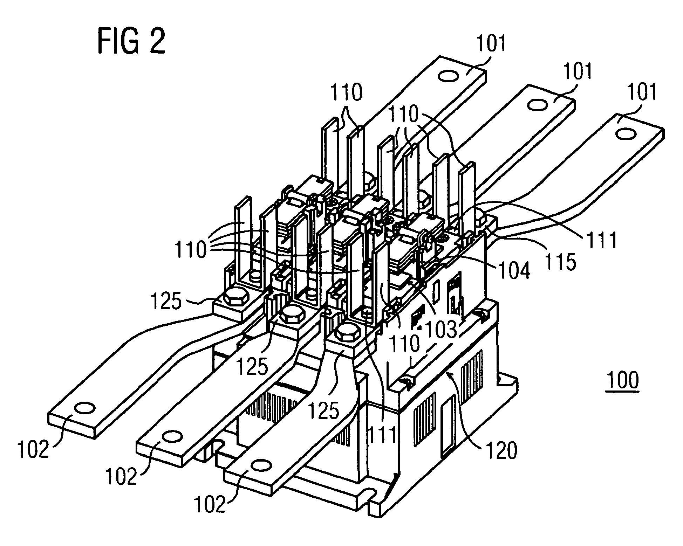

FIG 2 zeigt ein mögliches Überbrückungsteil 100, dessen maximal zulässiger Strom durch die maximal zulässige Erwärmung der den Strom führenden Metallteile, auch Strombahnen 115, 125 genannt, bestimmt wird. Die beweglichen Schaltstücke 104 werden durch den in den Sockel 210 montierten Antriebsmechanismus so gesteuert, dass sie sich zu bzw. weg von den festen Schaltstücken 103 bewegen und somit die Strombahnen 115, 125 elektrisch leitend verbinden bzw. trennen.

Da das Überbrückungsteil 100 keine Lichtbogenkammer aufweist, ist es möglich, durch verbesserte Kühlung der Strombahnen 115, 125 den maximal zulässigen Strom unter Einhaltung der maximal zulässigen Erwärmung zu erhöhen. Dann können Oberflächen vergrößernde Maßnahmen 110 nahe dem festen Schaltstück 103 eingesetzt werden.

Als mögliche Oberflächen vergrößernde Maßnahmen 110 kommen zum Beispiel Oberflächen vergrößernde Bleche oder Kühlrippen in Frage, die an den Strombahnen 115, 125 befestigt sind, bevorzugt mit mindestens einem Befestigungselement 111 wie eine Schraube oder einem Bolzen. Einige Ausführungsmöglichkeiten zu den Kühlmaßnahmen sind in der DE 10 2006 057 814.7 genauer beschrieben.

Die beweglichen bzw. festen Schaltstücke 103, 104 und die Stromschienen 115, 125 erwärmen sich im Betrieb. Auch die optional einsetzbaren Kühlmaßnahmen 110 erwärmen sich im Betrieb. Daher funktionieren die beweglichen bzw. festen Schaltstücke 103, 104, die Stromschienen 115, 125 und optional auch die Kühlmaßnahmen 110 als geräteinterne Wärmequellen.

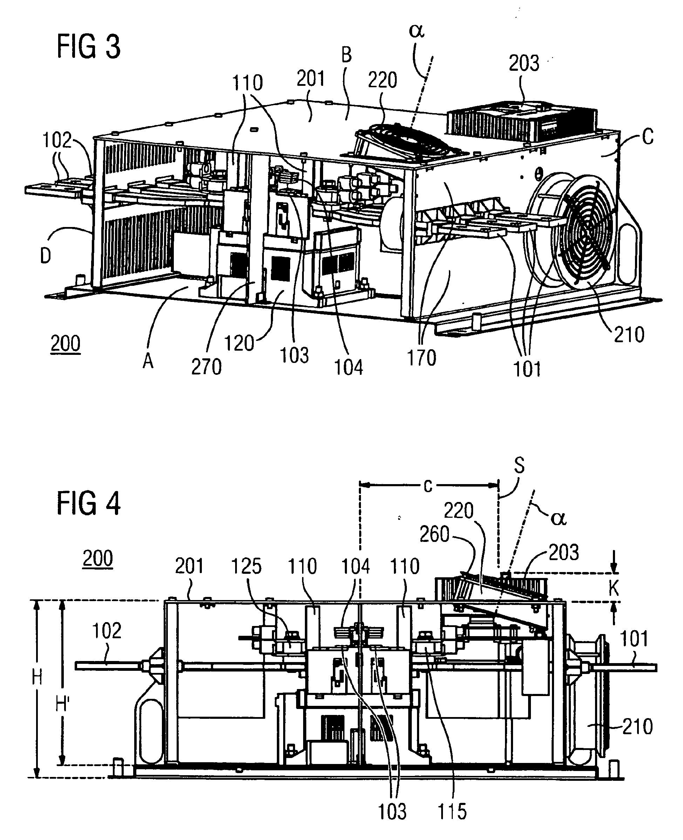

FIG 3 zeigt eine perspektivische Darstellung eines Sanftanlaufgeräts 200 mit dem Überbrückungsteil 100 aus FIG 2 und mit einem Gebläse 220 für dessen Kühlung. FIG 4 zeigt eine seitliche Ansicht des Sanftanlaufgeräts. Sowohl in der FIG 3 als auch in der FIG 4 ist die Seitenwand A abgenommen worden.

Das schräg eingebaute Gebläse 220 bläst bevorzugt direkt auf die Stromschienen 115 der ausgangsseitigen Stromanschlüsse 101. Die Drehachse α des Gebläses 220 ist nicht senkrecht zu dem Gehäusedeckel B bzw. zu der Gehäusewand, sondern von der Senkrechten S abgeneigt.

Durch die schräge Einbaulage des Gebläses 220 entsteht im Betrieb eine Luftströmung über die Oberflächen vergrößernden Maßnahmen 110 und die Strombahnen 115, 125 hin zu den Stromschienen für die eingangsseitigen Stromanschlüsse 102. Die erwärmte Luft tritt durch die perforierte eingangsseitige Gerätewand D nach außen und stellt somit den Abtransport der Verlustwärme des Überbrückungsteils 100 aus dem Sanftanlaufgerät 200 sicher. Da das Gebläse 220 für eine Kühlung sorgt, kann die Unterseite C ohne Perforierung 170 konzipiert werden.

Um mögliche Beschädigungen an dem Gebläse 220 zu vermeiden und um die Geräteabmessungen H, H' nicht zu vergrößern, wird das Gebläse 220 bevorzugt gerade nur so schräg gestellt, dass seine oberste Kante 260 nicht höher liegt als die höchste Stelle des Steuerteils 203, d.h. die Abmessung K in der FIG 4 ist maßgebend für den Montierwinkel.

Ein Luftleitblech 270, das seitlich am Überbrückungsteil 100 angeordnet ist, verhindert, dass Teile des Luftstroms in Richtung der Stromschienen 102 des eingangsseitigen Anschlusses strömen, ohne die Stromschienen 115, 125 und die Kühlkörper 110 umströmt und ausreichend gekühlt zu haben. Anstatt eines Luftleitbleches 270 können auch zwei oder mehr Luftleitbleche eingesetzt werden, möglichst auch beidseitig des Überbrückungsteils 100.

Durch den schrägen Einbau des Gebläses 220 in den Gehäusedeckel B kann das Gebläse 220 mit ausreichendem Abstand c zum Überbrückungsteil 100 platziert werden, so dass die Gefahr von Lichtbogenüberschlägen auf das Gebläse 220 vermieden oder reduziert wird.

Bei dieser Gebläseplatzierung ist eine so gute Kühlwirkung erreichbar, dass für das Überbrückungsteil 100 eine Stromerhöhung von ca. 20 bis 40 % erreichbar ist, in einem konkreten Fall waren es 25%. Dabei kann die Gerätehöhe H von der alten Abmessung für ein Sanftanlaufgerät ohne ein zusätzliches Gebläse nicht wesentlich abweichen.

Obgleich die Erfindung mit Beispielen beschrieben wurde, versteht der Fachmann, dass sie sich nicht dadurch beschränken lässt. Vielmehr ist die Erfindung anhand der Patentansprüche auszulegen. Insbesondere kann das Gebläse als Lüfter ausgebildet sein, und statt Luft kann auch ein anderes passendes Fluid als Kühlmittel benutzt werden.

## Patentansprüche

1. Sanftanlaufgerät (200) mit einem Gehäuse (201) und mit elektrischen Komponenten (103, 104, 110, 115, 125) innerhalb des Gehäuses (201) als Wärmequellen, wobei das Sanftanlaufgerät (200) mindestens eine Kühlanordnung für seine elektrischen Komponenten aufweist, und wobei die Kühlanordnung mindestens ein Gebläse (220) aufweist,
**dadurch gekennzeichnet, dass** das Gebläse in einer Öffnung einer Gehäusewand (201) schräg eingebaut ist, so dass die Drehachse (α) des Gebläses (220) zur Senkrechten (S) der Gehäusewand (201) geneigt ist, wobei die zu kühlenden elektrischen Komponenten (103, 104, 110, 115, 125) als potenzielle geräteinterne Wärmequelle mindestens eine Schaltstelle (103, 104) mit einem festen und einem beweglichen Schaltstück (103, 104) zum Unterbrechen eines elektrischen Stroms umfassen, wobei das Gebläse in der Öffnung in der Gehäusewand (201) derart angeordnet ist, dass es im Betrieb die elektrischen Komponenten (103, 104, 110, 115, 125) kühlt.

2. Sanftanlaufgerät (200) nach Anspruch 1, wobei die Schaltstelle (103, 104) ausgebildet ist, einen elektrischen Strom ohne Verwendung einer Lichtbogenlöschkammer zu unterbrechen.

3. Sanftanlaufgerät (200) nach Anspruch 2, wobei das Gebläse (220) entfernt von der mindestens einen Schaltstelle (103, 104) gesetzt ist.

4. Sanftanlaufgerät (200) nach Anspruch 2 oder 3, wobei die Drehachse (α) zu der mindestens einen Schaltstelle (103, 104) gerichtet oder geneigt ist.

5. Sanftanlaufgerät (200) nach einem der vorigen Ansprüche 1 bis 4, wobei das Sanftanlaufgerät mindestens eine Strombahn (115, 125) aufweist, die eine Oberfläche aufweist und wobei die Drehachse (α) so gewählt ist, dass das Gebläse (220) im Betrieb eine Fluidströmung entlang der Oberfläche erzeugt.

6. Sanftanlaufgerät (200) nach Anspruch 5, wobei die Oberfläche im Wesentlichen flach ist.

7. Sanftanlaufgerät (200) nach einem der vorhergehenden Ansprüche 1 bis 6, wobei das Sanftanlaufgerät (200) Sanftanlaufgerät mindestens einen Halbleiterleistungsteil, einen Steuerteil (203) und mindestens einen lichtbogenlöschkammerlosen Überbrückungsteil (100) aufweist, wobei das Überbrückungsteil (100) die zu kühlenden elektrischen Komponente aufweist, die im Betrieb als potenzielle geräteinterne Wärmequelle (103, 104, 110, 115, 125) funktionieren.

8. Sanftanlaufgerät (200) nach Anspruch 7, wobei das Überbrückungsteil das bewegliche und feste Schaltstück (103,104) umfasst und das Gebläse (220) der Kühlung des Überbrückungsteils (100) dient.

9. Sanftanlaufgerät (200) nach Anspruch 8, wobei ein Luftleitblech (270) seitlich am Überbrückungsteil (100) angeordnet ist.

10. Sanftanlaufgerät (200) nach Anspruch 1, wobei das Gebläse (220) gerade nur so schräg gestellt ist, dass seine oberste Kante (260) nicht höher liegt als die höchste Stelle eines Steuerteils des Sanftanlaufgerätes (200).

11. Sanftanlaufgerät (200) nach Anspruch 1, wobei die Gehäusewand (201) der Gehäusedeckel (B) ist.

12. Sanftanlaufgerät (200) nach Anspruch 1, wobei die Öffnung in der Gehäusewand (201) in das Geräteinnere des Sanftanlaufgerätes (200) führt.

## Claims

1. Soft starter (200) having a housing (201) and having electrical components (103, 104, 110, 115, 125) within the housing (201) as heat sources, wherein the soft starter (200) has at least one cooling arrangement for its electrical components, and wherein the cooling arrangement has at least one fan (220),
**characterized in that** the fan is arranged inclined in an opening in a housing wall (201) such that the rotation axis (α) of the fan (220) is at an angle to the normal (S) to the housing wall (201) wherein the electrical components (103, 104, 110, 115, 125) to be cooled as a potential appliance-internal heat source comprise at least one switching point (103, 104) with a fixed and a movable switching piece (103, 104) for interrupting an electric current, wherein the fan is arranged in the opening in the housing wall (201) in such a way that it cools the electrical components (103, 104, 110, 115, 125) during operation.

2. Soft starter (200) according to Claim 1, wherein the switching point (103, 104) is designed to interrupt an electric current without using an arc quenching chamber.

3. Soft starter (200) according to Claim 2, wherein the fan (220) is located at a distance from the at least one switching point (103, 104).

4. Soft starter (200) according to Claim 2 or 3, wherein the rotation axis (α) is directed at or is at an angle to the at least one switching point (103, 104).

5. Soft starter (200) according to one of the preceding Claims 1 to 4, wherein the soft starter has at least one current path (115, 125), which has a surface, and wherein the rotation axis (α) is selected such that the fan (220) produces a fluid flow along the surface during operation.

6. Soft starter (200) according to Claim 5, wherein the surface is essentially flat.

7. Soft starter (200) according to one of the preceding Claims 1 to 6, wherein the soft starter (200) has at least one semiconductor power section, a control section (203) and at least one bridging section (100) without an arc quenching chamber, wherein the bridging section (100) has the electrical components to be cooled and which act as a potential appliance-internal heat source (103, 104, 110, 115, 125) during operation.

8. Soft starter (200) according to Claim 7, wherein the bridging section comprises the movable and fixed switching piece (103, 104) and the fan (220) serves for cooling the bridging section (100).

9. Soft starter (200) according to Claim 8, wherein an air guide plate (270) is arranged at the side of the bridging section (100).

10. Soft starter (200) according to Claim 1, wherein the fan (220) is positioned only just at an angle such that its uppermost edge (260) is no higher than the highest point of a control section of the soft starter (200).

11. Soft starter (200) according to Claim 1, wherein the housing wall (201) is the housing cover (B).

12. Soft starter (200) according to Claim 1, wherein the opening in the housing wall (201) leads into the appliance interior of the soft starter (200).

## Revendications

1. Appareil ( 200 ) de démarrage en douceur comportant une enveloppe ( 201 ) et des composants ( 103, 104, 110, 115, 125 ) électriques à l'intérieur de l'enveloppe ( 201 ) comme sources de chaleur, l'appareil ( 200 ) de démarrage en douceur ayant au moins un dispositif de refroidissement de ses composants électriques et le dispositif de refroidissement ayant au moins une soufflante ( 220 ),
**caractérisé en ce que** la soufflante est montée de manière inclinée dans une ouverture d'une paroi ( 201 ) de l'enveloppe de manière à ce que l'axe ( α ) de rotation de la soufflante ( 200 ) soit incliné par rapport à la perpendiculaire ( S ) à la paroi ( 201 ) de l'enveloppe, les composants ( 103, 104, 110, 115, 125 ) électriques à refroidissement comprenant, comme source de chaleur potentielles internes à l'appareil, au moins un poste ( 103, 104 ) de commutation ayant une pièce ( 103 ) de commutation fixe et une pièce ( 104 ) de commutation mobile pour interrompre un courant électrique, la soufflante étant disposée dans l'ouverture de la paroi ( 201 ) de l'enveloppe de manière à refroidir en fonctionnement les composants ( 103, 104, 110, 115, 125 ) électriques.

2. Appareil ( 200 ) de démarrage en douceur suivant la revendication 1, dans lequel le poste ( 103, 104 ) de commutation est constitué pour interrompre un courant électrique sans utiliser une chambre d'extinction d'arc électrique.

3. Appareil ( 200 ) de démarrage en douceur suivant la revendication 2, dans lequel la soufflante ( 220 ) est éloignée du au moins un poste ( 103, 104 ) de commutation.

4. Appareil ( 200 ) de démarrage en douceur suivant la revendication 2 ou 3, dans lequel l'axe ( α ) de rotation est dirigé sur le au moins un poste ( 103, 104 ) de commutation où est incliné par rapport à lui.

5. Appareil ( 200 ) de démarrage en douceur suivant l'une des revendications précédentes 1 à 4, dans lequel l'appareil de démarrage en douceur a au moins une piste ( 115, 125 ) de courant, qui a une surface, et dans lequel l'axe ( α ) de rotation est choisi de manière à ce que la soufflante ( 220 ) produise en fonctionnement un courant de fluide le long de la surface.

6. Appareil ( 200 ) de démarrage en douceur suivant la revendication 5, dans lequel la surface est sensiblement plate.

7. Appareil ( 200 ) de démarrage en douceur suivant l'une des revendications précédentes 1 à 6, dans lequel l'appareil ( 200 ) de démarrage en douceur a au moins une partie de puissance à semi-conducteur, une partie ( 203 ) de commande et au moins une partie ( 100 ) de shuntage sans champ d'extinction d'arc électrique, la partie ( 100 ) de shuntage ayant les composants électriques à refroidir qui, en fonctionnement, servent de sources ( 103, 104, 110, 115, 125 ) de chaleur potentielles internes à l'appareil.

8. Appareil ( 200 ) de démarrage en douceur suivant la revendication 7, dans lequel la partie de shuntage comprend la pièce ( 103 ) de commutation mobile et la pièce ( 104 ) de commutation fixe et la soufflante ( 220 ) sert au refroidissement de la partie ( 100 ) de shuntage.

9. Appareil ( 200 ) de démarrage en douceur suivant la revendication 8, dans lequel une chicane ( 270 ) de déviation de l'air est disposée latéralement à la partie ( 100 ) de shuntage.

10. Appareil ( 200 ) de démarrage en douceur suivant la revendication 1, dans lequel la soufflante ( 220 ) est précisément inclinée seulement de manière à ce que son bord ( 260 ) le plus haut ne soit pas plus haut que le point le plus haut d'une partie de commande de l'appareil ( 200 ) de démarrage en douceur.

11. Appareil ( 200 ) de démarrage en douceur suivant la revendication 1, dans lequel la paroi ( 201 ) de l'enveloppe est le couvercle ( B ) de l'enveloppe.

12. Appareil ( 200 ) de démarrage en douceur suivant la revendication 1, dans lequel l'ouverture dans la paroi ( 201 ) de l'enveloppe conduit à l'intérieur de l'appareil ( 200 ) de démarrage en douceur.
